(19) Europäisches Patentamt
European Patent Office
Office européen des brevets

(11) EP 0 367 132 B1

(12) **EUROPÄISCHE PATENTSCHRIFT**

(45) Veröffentlichungstag und Bekanntmachung des Hinweises auf die Patenterteilung:
**02.04.1997 Patentblatt 1997/14**

(51) Int Cl.$^{6}$: **G03F 7/004**

(21) Anmeldenummer: **89119967.1**

(22) Anmeldetag: **27.10.1989**

(54) **Strahlungsempfindliches Gemisch**

Light-sensitive composition

Composition photosensible

(84) Benannte Vertragsstaaten:
**BE DE FR GB IT NL SE**

(30) Priorität: **04.11.1988 DE 3837513**

(43) Veröffentlichungstag der Anmeldung:
**09.05.1990 Patentblatt 1990/19**

(73) Patentinhaber: **BASF Aktiengesellschaft**
**67063 Ludwigshafen (DE)**

(72) Erfinder:
- **Nguyen-Kim, Son, Dr.**
  **D-6944 Hemsbach (DE)**
- **Hoffmann, Gerhard, Dr.**
  **D-6701 Otterstadt (DE)**
- **Schwalm, Reinhold, Dr.**
  **D-6706 Wachenheim (DE)**
- **Binder, Horst**
  **D-6840 Lampertheim (DE)**

(56) Entgegenhaltungen:
**EP-A- 0 297 443**

Anmerkung: Innerhalb von neun Monaten nach der Bekanntmachung des Hinweises auf die Erteilung des europäischen Patents kann jedermann beim Europäischen Patentamt gegen das erteilte europäische Patent Einspruch einlegen. Der Einspruch ist schriftlich einzureichen und zu begründen. Er gilt erst als eingelegt, wenn die Einspruchsgebühr entrichtet worden ist. (Art. 99(1) Europäisches Patentübereinkommen).

EP 0 367 132 B1

Printed by Jouve, 75001 PARIS (FR)

## Beschreibung

Die Erfindung betrifft positiv arbeitende strahlungsempfindliche Gemische, die ein in Wasser unlösliches, in wäßrig-alkalischen Lösungen lösliches Bindemittel, eine unter Einwirkung von Strahlung eine Säure bildende Verbindung und eine organische Verbindung, die durch säurekatalytische Einwirkung verseift und decarboxyliert wird, wodurch die Alkalilöslichkeit des Gemisches erhöht wird, enthalten. Diese Gemische sind sensitiv gegenüber UV-, Elektronen- und Röntgenstrahlen und eignen sich besonders als Resistmaterial.

Positiv arbeitende strahlungsempfindliche Gemische sind bekannt und besonders positiv arbeitende Resistmaterialien, die o-Chinondiazide in wäßrig-alkalisch löslichen Bindemitteln, z.B. Novolaken oder Poly(p-vinylphenol)en, enthalten, werden kommerziell eingesetzt. Die Empfindlichkeit dieser Systeme gegenüber Strahlung, insbesondere kurzwelliger Strahlung, ist jedoch teilweise unbefriedigend.

Empfindlichkeitserhöhungen in strahlungsempfindlichen Systemen, die in der Primärphotoreaktion eine Spezies erzeugen, die dann unabhängig von der Strahlung eine katalytische Sekundärreaktion auslösen, sind beschrieben. So sind in der US-A 3,915,706 beispielsweise Photoinitiatoren beschrieben, die eine starke Säure erzeugen, die dann in einer Sekundärreaktion säurelabile Gruppen, wie Polyaldehydgruppierungen spalten.

Weiterhin sind strahlungsempfindliche Gemische auf Basis von säurespaltbaren Verbindungen bekannt, die als Bindemittel ein wäßrig-alkalisch lösliches Polymer sowie eine Verbindung die photochemisch eine starke Säure bildet und eine weitere Verbindung mit durch Säure spaltbaren Bindungen, die durch die Einwirkung der Säure ihre Löslichkeit in einem alkalischen Entwickler erhöhen, enthalten (vgl. DE-A 3 406 927). Als photochemisch eine starke Säure bildende Verbindungen werden Diazonium-, Phosphonium-, Sulfonium- und Iodonium-, sowie Halogenverbindungen genannt. Die Verwendung dieser Oniumsalze als photochemische Säurespender in Resistmaterialien ist z.B. auch aus US-A 4,491,628 bekannt. Einen überblick über die Anwendung von Oniumsalzen in Resistmaterialien gibt Crivello in Org. Coatings and Appl. Polym. Sci., 48, p. 65-69 (1985).

Strahlungsempfindliche Gemische von Polymeren mit säurelabilen Seitengruppen und photochemischen Säurespendern sind z.B. aus US-A 4,491,628 und FR-A 2,570,844 bekannt. Diese polymeren Bindemittel sind jedoch hydrophob und werden erst nach der Belichtung alkalilöslich.

Copolymere mit phenolischen und säurelabilen Gruppen, wie beispielsweise Poly-(p-hydroxistyrol-co-t-butoxicarbonyloxistyrol), sind aus J. Polym. Sci., Part A, Polym. Chem. Ed., Vol. 24, 2971-2980 (1986) bekannt. Verwendet man jedoch diejenigen Copolymeren dieser Gruppe, die noch alkalilöslich sind, in Verbindung mit den kommerziellen Sulfoniumsalzen, wie Triphenylphosphoniumhexafluoroarsenat, wie auch in US-A 4,491,628 beschrieben, so haben diese Gemische den Nachteil, daß ein sehr hoher Abtrag der unbelichteten Bereiche stattfindet, da die genannten Sulfoniumsalze nicht genügend zur Löslichkeitsinhibierung beitragen. Weiterhin tragen diese Salze nach der Belichtung nicht zu einer Löslichkeitserhöhung der bestrahlten Bereiche in alkalischen Entwicklern bei, da keine alkalilöslichen Photoprodukte entstehen.

In der DE-A 37 21 741 werden strahlungsempfindliche Gemische beschrieben, die ein in wäßrig-alkalischen Lösungen lösliches polymeres Bindemittel enthalten sowie eine organische Verbindung, deren Löslichkeit in einem wäßrig-alkalischen Entwickler durch Einwirkung von Säure erhöht wird und die mindestens eine durch Säure spaltbare Gruppierung enthält, wobei diese organische Verbindung unter Einwirkung von Strahlung eine starke Säure erzeugt.

Aufgabe der vorliegenden Erfindung ist es, neue positiv arbeitende hochaktive strahlungsempfindliche Systeme für die Herstellung von Reliefstrukturen aufzuzeigen, die sich mit wäßrig-alkalischen Lösungen entwickeln lassen und die Herstellung von im kurzwelligen UV lichtempfindlichen Schichten ermöglichen.

Dazu soll ein strahlungsempfindliches Gemisch, das ein in Wasser unlösliches, in wäßrig-alkalischer Lösung lösliches Bindemittel, eine säurelabile organische Verbindung, die durch Einwirkung von Säure verseift und bei erhöhter Temperatur decarboxyliert wird, und eine bei Bestrahlung eine starke Säure bildende Verbindung enthält, bildmäßig bestrahlt, erwärmt und die bildmäßig bestrahlten Schichtbereiche mit Entwicklerlösung ausgewaschen werden.

Überraschenderweise wurde gefunden, daß durch den Einsatz von ß-Ketocarbonsäureestern als die Löslichkeit der Bindemittel in wäßrig-alkalischen Lösungen inhibierenden Verbindungen hochaktive strahlungsempfindliche Systeme für die Herstellung von Reliefstrukturen im kurzwelligen UV erhalten werden, die sich besonders durch sehr gute Reproduzierbarkeit und hohe Auflösung auszeichnen.

Gegenstand der vorliegenden Erfindung ist ein strahlungsempfindliches Gemisch, im wesentlichen bestehend aus

(a) einem in Wasser unlöslichen, in wäßrig-alkalischen Lösungen lösliche Bindemittel oder Bindemittelgemisch,

(b) einer bei Bestrahlung eine starke Säure bildenden Verbindung und

(c) einer oder mehreren die Löslichkeit von (a) in wäßrig-alkalischen Lösungen inhibierenden organischen Verbindungen,

das dadurch gekennzeichnet ist, daß als organische Verbindung (c) ein β-Ketosäureester der allgemeinen Formel (I)

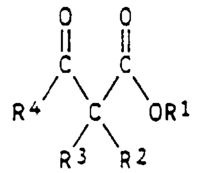

(I)

ist, worin

$R^1$ = Alkyl, Cycloalkyl, Aralkyl oder sauerstoffhaltiger heterocyclischer Rest,

$R^2$ und $R^3$ untereinander gleich oder verschieden sind und für Wasserstoff, Halogen, Alkyl, Cycloalkyl, Aralkyl, Aryl, Alkoxy oder -CO-$OR^1$ stehen, oder $R^1$ mit $R^2$, oder $R^3$ mit $R^4$ über $-(CH_2)_n-$ mit n = 2 bis 5 jeweils einen Ring bilden,

$R^4$ = Alkyl, Cycloalkyl, Aryl oder $-CH_2$-CO-$OR^1$,

oder mindestens eine Verbindung aus der Gruppe Acetessigsäure-trimethylsilylester, Propionylmalonsäure-di(trimethylsilyl)ester, Benzoyl-malonsäure-di(trimethylsilyl)ester, Acetylbrommalonsäure-cycloisopropyl-idenester, Acetylmethylmalonsäure-cycloisopropylidenester, Brom-propionyl-malonsäure-cycloisapropylider ester, Methyl-propionylmalonsäure-cyclaisopropylidenester, Verbindungen der Formel

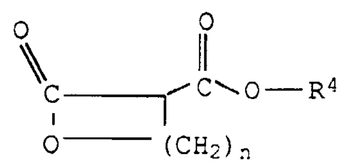

mit n = 2 bis 4 und Verbindungen der allgemeinen Formel (IV)

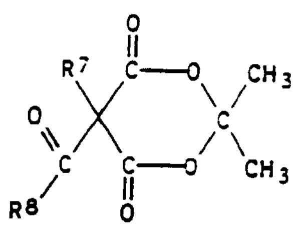

(IV)

worin

$R^7$ = Br oder $CH_3$
$R^8$ = $CH_3$ oder $C_2H_5$

eingesetzt wird.

Das strahlungsempfindliche Gemisch kann als Bindemittel (a) ein phenolisches Harz, wie beispielsweise Novolake mit mittleren Molekulargewichten $\overline{M}_n$ zwischen 300 und 20 000, Copolymerisate aus p-Hydroxystyrol und p-tert.-Butoxycarbonyloxistyrol, Copolymerisate aus p-Hydroxystyrol und Alkoxystyrol sowie Copolymerisate aus p-Hydroxystyrol und 2-Tetrahydropyranyloxistyrol oder deren Gemische enthalten.

Bevorzugt als bei Bestrahlung eine starke Säure bildende Verbindungen (b) sind Sulfoniumsalze der allgemeinen Formel (II)

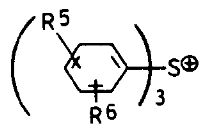 $X^{\ominus}$ (II)

und Jodoniumsalze der allgemeinen Formel (III)

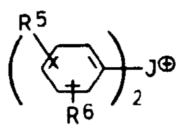 $X^{\ominus}$ (III),

worin $R^5$ und $R^6$ untereinander gleich oder verschieden sind und für H, OH oder einen der Reste

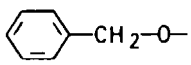 , $(C_1\text{- bis }C_4\text{-Alkyl})_3Si{-}O{-}$ , 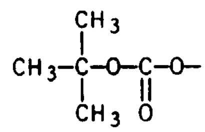 ,

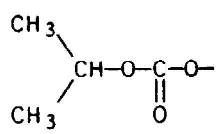 , 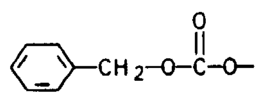

stehen und $X^{\ominus} = Cl^{\ominus}$, $Br^{\ominus}$, $ClO_4^{\ominus}$, Hexafluoroarsenat, Hexafluoroantimonat, Hexafluorophosphat und/oder Tetrafluoroborat ist.

Bevorzugte β-Ketocarbonsäureester sind Acetessigsäureester aus der Gruppe Acetessigsäure-tert.-butylester, Acetessigsäureisobutylester, Acetessigsäure-2-tetrahydropyranylester, Acetessigsäure-trimethylsilylester und Acetessigsäurecyclohexylester, sowie Acetondicarbonsäure-dimethylester, -diethylester oder -di-tert.-butylester, Malonsäuredialkylesterderivate aus der Gruppe Acetyl-malonsäuredimethylester, Propionyl-malonsäuredimethylester, Propionyl-malonsäurediethylester, Propionyl-malonsäureditert.-butylester, Acetylmalonsäuredi-iso-butylester, Propionylmalonsäuredi(trimethylsilyl)ester und Benzoyl-maleonsäure-di(trimethylsilyl)ester, sowie Verbindungen der allgemeinen Formel (IV)

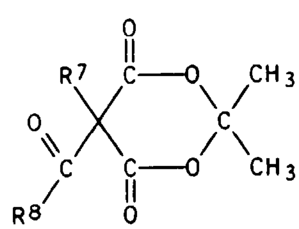 (IV)

worin

$R^7 =$ Br oder $CH_3$
$R^8 =$ $CH_3$ oder $C_2H_5$.

Gegenstand der vorliegenden Erfindung ist auch ein Verfahren zur Herstellung von Reliefstrukturen oder zur Strukturierung von Wafern durch Auftragen von Photoresistlösungen in einer Schichtdicke von 0,1 bis 5 µm auf ein in üblicher Weise vorbehandeltes Substrat, Trocknen, bildmäßige Belichtung, gegebenenfalls Erhitzen auf Temperaturen von bis zu 150°C, und Entwickeln mit einer wäßrig-alkalischen Lösung, wobei Photoresistlösungen eingesetzt werden, die erfindungsgemäße strahlungsempfindliche Gemische enthalten.

Das erfindungsgemäße Verfahren ist besonders vorteilhaft, da es sehr gute Reproduzierbarkeit gewährleistet. Die

damit erhaltenen Reliefstrukturen zeichnen sich durch hohe Auflösung aus.

Zu den Aufbaukomponenten des erfindungsgemäßen strahlungsempfindlichen Gemisches ist im einzelnen folgendes auszuführen.

a) Als in Wasser unlösliche, in wäßrig-alkalischen Lösungen lösliche Bindemittel oder Bindemittelgemische kommen wegen der meist erforderlichen Plasmaätzstabilität im allgemeinen phenolische Harze in Betracht, wie z.B. Novolake mit Molekulargewichten $\overline{M}_n$ zwischen 200 und 20.000, vorzugsweise zwischen 300 und 2000 g/mol, für Belichtung im kurzwelligen UV-Bereich (≦ 300 nm) insbesondere Novolake auf Basis p-Kresol/Formaldehyd, Poly (p-hydroxystyrole), Poly(p-hydroxy-α-methyl-styrole), wobei diese Poly(p-hydroxystyrole) im allgemeinen Molekulargewichte $\overline{M}_n$ zwischen 200 und 100.000, vorzugsweise 1000 und 40.000 g/mol aufweisen, wobei diese Poly(p-hydroxystyrole) auch in bekannter Weise durch Umsetzung (polymeranaloge Umsetzung) ihrer Hydroxylgruppen mit z.B. Chloressigsäure, Chloressigsäureester, Alkylhalogenid, Benzylhalogenid, 3,4-Dihydropyran, Dihydrofuran, Chlorkohlensäureester und/oder Pyrokohlensäureester modifiziert sein können. Die so erhältlichen und im vorliegenden Falle auch als Copolymerisate verstandenen modifizierten polymeren Bindemittel (a) sind beispielsweise solche aus p-Hydroxystyrol und p-tert.-Butoxycarbonyloxistyrol, p-Hydroxystyrol und Alkoxystyrol, p-Hydroxystyrol und 2-Tetrahydropyranyloxistyrol. Bevorzugte Copolymere von p-Hydroxystyrol, die seitenständige Schutzgruppen tragen, enthalten im wesentlichen Gruppierungen der Formel

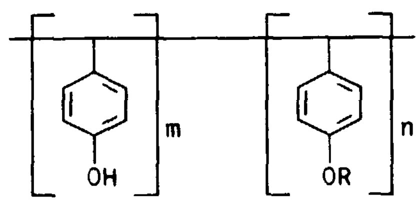

worin n ≤ m und

R = 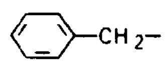 , 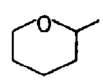 , 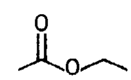 ,

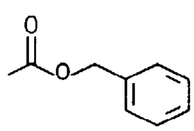 , 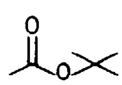 , 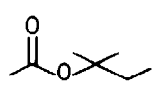

d.h. Copolymere mit p-Benzyl-oxistyrol-, p-(2-Tetrahydropyranyl)-oxistyrol-, p-(iso-Propyl-oxicarbonyl)-oxistyrol-, p-(Cyclohexyl-oxicarbonyl)-oxistyrol-, p-(Benzyloxicarbonyl)-oxistyrol-, p-(t.Butyloxicarbonyl)-oxistyrol- und/oder p-(t.Pentyloxicarbonyl)-oxistyroleinheiten. Es eignen sich auch Gemische der obengenannten Bindemittel (a). Bindemittel (a) ist im erfindungsgemäßen Gemisch im allgemeinen in Mengen von 45 bis 95, vorzugsweise 80 bis 90 Gew.%, bezogen auf die Gesamtmenge des strahlungsempfindlichen Gemisches (a)+(b)+(c) enthalten.

b) Als bei Bestrahlung eine starke Säure bildende Verbindungen (b) kommen im Prinzip alle Verbindungen in Frage, die diese Eigenschaft aufweisen und so als Säurespender wirksam sind. Für die Bestrahlung mit kurzwelligen UV-Strahlen sind jedoch Iodonium- und insbesondere Sulfoniumsalze bevorzugt. Diese entsprechen der allgemeinen Formel (II) bzw. (III)

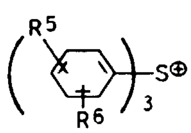 $X^{\ominus}$ (II)

bzw.

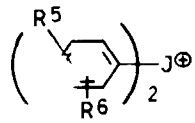 $X^{\ominus}$ (III),

worin

$R^5$ und $R^6$ = H, (Triphenylsulfoniumsalz bzw. Diphenyljodoniumsalz), OH

= 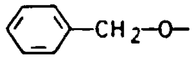 z.B. Tris(4-benzyloxiphenyl)-sulfoniumsalz

= ($C_1$- bis $C_4$-Alkyl)$_3$Si-O- z.B. Tris(trimethylsilyloxy-phenyl)sulfoniumsalz

= 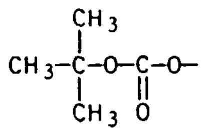 (Tris(4-tert.-butoxicarbonyloxi-phenyl)sulfoniumsalz

= 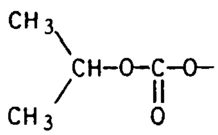 (Tris(4-isopropyloxicarbonyl-oxiphenyl)sulfoniumsalz)

= 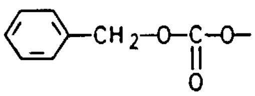 (Tris(4-benzylcarbonyloxiphenyl)-sulfoniumsalz)

$X^{\ominus}$ = $Cl^{\ominus}$, $Br^{\ominus}$, $ClO_4^{\ominus}$, $AsF_6^{\ominus}$, $PF_6^{\ominus}$, $SbF_6^{\ominus}$ und/oder $BF_4^{\ominus}$.

Auch Gemische der unter (b) genannten Verbindungen können eingesetzt werden. Komponente (b) ist im erfindungsgemäßen strahlungsempfindlichen Gemisch im allgemeinen in Mengen von 0,1 bis 20, vorzugsweise 2 bis 10 Gew.%, bezogen auf die Gesamtmenge des strahlungsempfindlichen Gemisches (a)+(b)+(c) enthalten.

c) Als die Löslichkeit des Bindemittels (a) inhibierende organische Verbindung (c) werden erfindungsgemäß β-Ketocarbonsäureester der allgemeinen Formel (I) eingesetzt,

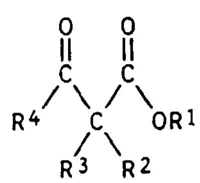 (I)

worin

$R^1$ = Alkyl wie z.B. n-Alkyl mit 1 bis 5 Kohlenstoffatomen, sec.-Alkyl mit 3 bis 6 Kohlenstoffatomen, tert.-Alkyl mit 4 oder 5 Kohlenstoffatomen, beispielsweise Methyl, Ethyl, n-Propyl, i-Propyl, n-Butyl, iso-Butyl, tert.-Butyl, Cycloalkyl wie z.B. Cyclohexyl, Aralkyl wie z.B. Benzyl, oder ein sauerstoffhaltiger heterocyclischer Rest wie z.B.

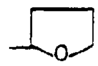 , 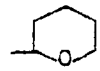 ;

R² und R³ untereinander gleich oder verschieden sind und für Wasserstoff, Halogen, wie z.B. Cl und Br, Alkyl wie z.B. n-Alkyl mit 1 bis 5 Kohlenstoffatomen, wie Methyl, Ethyl, sec.-Alkyl mit 3 bis 6 Konlenstoffatomen, wie Isopropyl und Isobutyl, Cycloalkyl wie Cyclohexyl, Aralkyl, wie Benzyl, Aryl, wie z.B. Phenyl, Alkoxy, wie z.B. Methoxy, Ethoxy, halogensubstituiertes Aryl, wie z.B. Chlorphenyl oder -CO-$OR^1$ stehen, oder $R^1$ mit $R^2$, oder $R^3$ mit $R^4$ über $-(CH_2)_n-$ mit n = 2 bis 5 jeweils einen Ring, beispielsweise einen 5- bis 7-gliedrigen Ring, bilden;

$R^4$ Alkyl, wie z.B. n-Alkyl mit 1 bis 5 Kohienstoffatomen, wie z.B. Methyl, Ethyl, Propyl, n-Butyl, sec.-A]kyl mit 3 bis 6 Kohlenstoffatomen, wie z.B. Isopropyl, Isobutyl, Cycloalkyl, wie z.B. Cyclohexyl, Aryl, wie z.B. Phenyl oder $-CH_2-C=O-OR^1$.

Weitere Beispiele für erfindungsgemäß geeignete β-Ketocarbonsäureester sind:

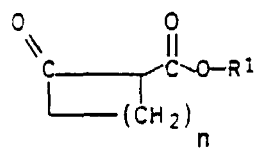

mit n = 3 bis 5

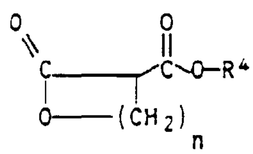

mit n = 2 bis 4

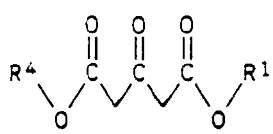

mit $R^1$=$R^4$ = n-Alkyl mit 1 bis 3 Kohlenstoffatomen, sec.-Alkyl mit 3 bis 6 Kohlenstoffatomen, tert.-Alkyl mit 4 bis 6 Kohlenstoffatomen;

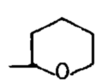 , 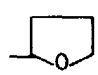

oder Benzyl ;

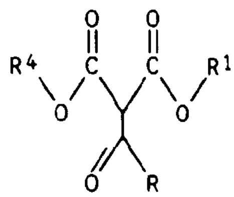

mit R = n-Alkyl mit 1 bis 3 Kohlenstoffatomen, Aryl, halogeniertes Aryl (z.B. Chlorphenyl) oder Benzyl und $R^1$ und $R^4$ wie oben angegeben.

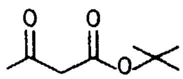

Acetessigsäure-tert.-butylester

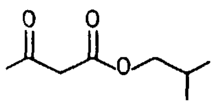

Acetessigsäure-iso-butylester

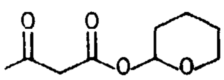

Acetessigsäure-2-tetrahydropyranyl-ester

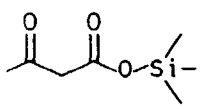

Acetessigsäure-trimethylsilylester

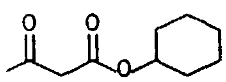

Acetessigsäure-cyclohexylester

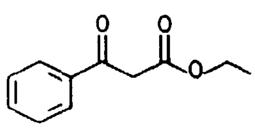

Ethyl-benzoylacetat

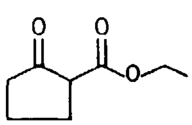

2-Carbethoxy-cyclopentanon

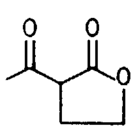

2-Acetyl-butyrolacton

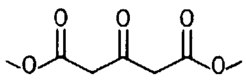
Acetondicarbonsäure-dimethylester

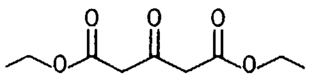
Acetondicarbonsäure-diethylester

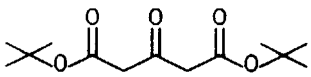
Acetondicarbonsäure-di-tert.-butylester

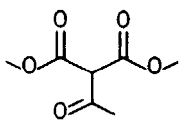
Acetylmalonsäure-dimethylester

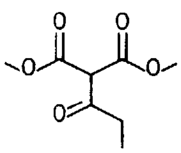
Propionylmalonsäure-dimethylester

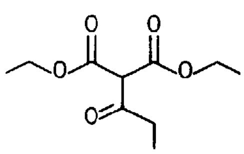
Propionyl-malonsäure-diethylester

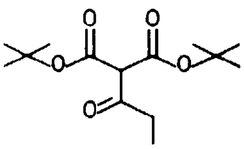
Propionyl-malonsäure-di-tert.-butylester

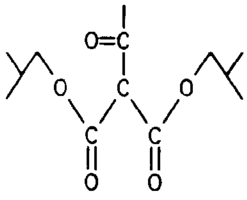
Acetyl-malonsäure-di-iso-butylester

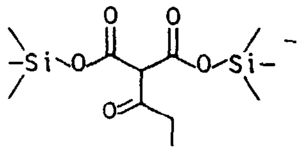

Propionyl-malonsäure-di-trimethyl-silylester

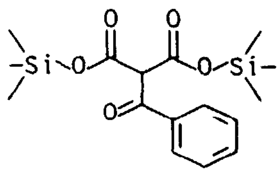

Benzoyl-malonsäure-di-trimethylsilylester

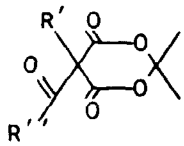

R′ = Br, R′′ = $CH_3$

Acetyl-brommalonsäure-cyclo-isopropylidenester

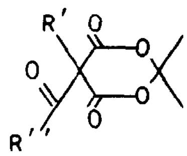

R′ = $CH_3$, R′′ = $CH_3$

Acetyl-methylmalonsäure-cyclo-isopropylidenester

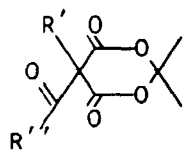

R′ = Br, R′′ = $C_2H_5$

Brom-propionylmalonsäure-cyclo-isopropylidenester

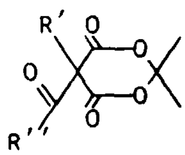

R′ = $CH_3$, R′′ = $C_2H_5$

Methyl-propionylmalonsäure-cyclo-isopropylidenester

Die Herstellung derartiger β-Ketocarbonsäureester ist allgemein bekannt.

Auch Gemische der obengenannten β-Ketocarbonsäureester können eingesetzt werden.

Die β-Ketocarbonsäureester (c) sind im erfindungsgemäßen strahlungsempfindlichen Gemisch im allgemeinen in Mengen von 3 bis 35, vorzugsweise 10 bis 25 Gew.%, bezogen auf die Gesamtmenge des Gemisches aus (a), (b) und (c) vorhanden.

Das erfindungsgemäße strahlungsempfindliche Gemisch kann zusätzlich noch weitere übliche Hilfs- und Zusatzstoffe enthalten.

Die erfindungsgemäßen Gemische werden bevorzugt in einem organischen Lösungsmittel gelöst, wobei der Feststoffgehalt im allgemeinen im Bereich zwischen 5 und 40 Gew.% liegt. Als Lösungsmittel kommen bevorzugt aliphatische Ketone, Ether und Ester, sowie Mischungen derselben in Frage. Besonders bevorzugt sind Alkylenglykol-monoalkylether, wie beispielsweise Ethyl-cellosolve, Butylglykol, Methyl-cellosolve und 1-Methoxy-2-propanol, Alkylenglykol-alkylether-ester, wie beispielsweise Methyl-cellosolve-acetat, Ethyl-cellosolve-acetat, Methyl-propylenglykol-acetat und Ethyl-propylenglykol-acetat, Ketone, wie beispielsweise Cyclohexanon, Cyclopentanon und Methyl-ethylketon, sowie Acetate wie Butylacetat und Aromaten, wie Toluol und Xylol. Die Auswahl der entsprechenden Lösungsmittel, sowie deren Mischung richtet sich nach der Wahl des jeweiligen phenolischen Polymers, Novolaks und der photoempfindlichen Komponente.

Weiterhin können andere Zusätze wie Haftvermittler, Netzmittel, Farbstoffe und Weichmacher zugesetzt werden.

Gegebenenfalls können auch Sensibilisatoren in geringen Mengen zugesetzt werden, um die Verbindungen im längerwelligen UV- bis hin zum sichtbaren Bereich zu sensibilisieren. Polycyclische Aromaten, wie Pyren und Perylen sind hierfür bevorzugt, jedoch können auch andere Farbstoffe, die als Sensibilisatoren wirken, verwendet werden.

Bei dem erfindungsgemäßen Verfahren zur Herstellung von Reliefmustern wird eine strahlungsempfindliche Aufzeichnungsschicht, die im wesentlichen aus dem erfindungsgemäßen strahlungsempfindlichen Gemisch besteht, bildmäßig in solcher Dosis bestrahlt, daß die Löslichkeit der belichteten Bereiche in wäßrig-alkalischen Lösungsmitteln zunimmt und diese bestrahlten Bereiche selektiv mit dem alkalischen Entwickler entfernt werden können.

Das erfindungsgemäße strahlungsempfindliche Gemisch eignet sich als Photoresist zur Herstellung von Reliefstrukturen für Halbleiterbauelemente.

Die das erfindungsgemäße strahlungsempfindliche Gemisch enthaltenden Photoresistlösungen werden im allgemeinen in Schichtdicken von 0,1 bis 5 µm, vorzugsweise 0,5 bis 1,5 µm auf geeignete Substrate, beispielsweise oberflächlich oxidierte Silizium-Wafer durch Aufschleudern (spin coating) aufgetragen, getrocknet (z.B. bei Temperaturen zwischen 70 und 130°C) und mit einer geeigneten Lichtquelle durch eine Photomaske bildmäßig belichtet. Als Lichtquellen eignen sich insbesondere kurzwellige UV-Strahlen (deep UV) mit Wellenlängen zwischen 200 und 300 nm. Besonders geeignete Lichtquellen sind Excimer-Laser von KrF (248 nm). Nach dem bildmäßigen Belichten wird - gegebenenfalls nach kurzem Ausheizen (post-bake) bei Temperaturen bis zu 150°C - mit üblichen wäßrig-alkalischen Entwicklerlösungen - im allgemeinen bei pH-Werten zwischen 12 und 14 - entwickelt, wobei die belichteten Stellen ausgewaschen werden. Die Auflösung liegt im Submikron-Bereich. Die für die erfindungsgemäßen strahlungsempfindlichen Gemische benötigte Belichtungsenergie liegt im allgemeinen zwischen 30 und 200 $mJ/cm^2$ bei Schichtdicken von 1 µm.

Die in den Beispielen angegebenen Teile und Prozente sind, soweit nicht anders angegeben, Gewichtsteile bzw. Gewichtsprozente.

Beispiel 1

Eine Photoresistlösung wird aus 80 Teilen Poly-(p-hydroxystyrol) (= kommerzielles Produkt von Polysciences Inc., MW 1500-7000 g/mol), 5 Teilen Triphenylsulfoniumhexafluoroarsenat (= Handelsprodukt der Firma ALFA), 15 Teilen Acetessigsäureisobutylester und 280 Teilen Ethylenglykol-monomethyletheracetat hergestellt und die Lösung anschließend durch ein Filter mit einem Porendurchmesser von 0,2 µm filtriert.

Die Resistlösung wird dann auf einen Siliciumwafer mit einer $SiO_2$-Oberfläche, der mit Hexamethyldisilazan als Haftvermittler überzogen ist, mit 4000 Upm/30 Sekunden aufgeschleudert, wobei eine Trockenschichtdicke von etwa 1 µm erhalten wird. Der Wafer wird während 3 Minuten auf einer Heizplatte bei 80°C getrocknet, anschließend mit einer bildmäßig strukturierten Testmaske in Kontakt gebracht und 3 Sekunden mit Excimer-Laser ($\lambda$ = 248 nm, E = 35 $mW/cm^2$) belichtet. Danach wird der Wafer 1 Minute bei 80°C ausgeheizt und mit einem Entwickler vom pH-Wert 12,1-13,4 entwickelt.

Beispiel 2

Eine Photoresistlösung wird aus 80 Teilen Poly-(p-hydroxystyrol), 6 Teilen Triphenylsulfoniumhexafluoroarsenat, 14 Teilen 2-Carbethoxy-cyclopentanon und 280 Teilen Ethylenglykol-monomethyletheracetat hergestellt. Es wird wie in Beispiel 1 verfahren, jedoch wurde 5 Sekunden belichtet, um die belichteten Bereiche unter den gleichen Bedingungen vollständig abzutragen.

Beispiel 3

Eine Photoresistlösung wird aus 80 Teilen Poly-(p-hydroxystyrol), 7 Teilen Triphenylsulfoniumhexafluoroarsenat, 13 Teilen 2-Acetylbutyrolacton und 280 Teilen Ethylenglykol-monomethyletheracetat hergestellt. Es wird wie in Beispiel 1 verfahren. Die Empfindlichkeit beträgt 160 $mJ/cm^2$.

Beispiel 4

Eine Photoresistlösung wird aus 75 Teilen Poly-(p-hydroxystyrol), 2 Teilen Triphenylsulfoniumhexafluoroarsenat, 23 Teilen Acetondicarbonsäuredimethylester und 280 Teilen Ethylenglykol-monomethyletheracetat hergestellt. Es wird

wie in Beispiel 1 verfahren. Die Empfindlichkeit beträgt 100 mJ/$cm^2$.

Beispiel 5

Eine Photoresistlösung wird aus 80 Teilen Poly-(p-hydroxystyrol), 5 Teilen Triphenylsulfoniumhexafluoroarsenat, 15 Teilen Propionyl-malonsäurediethylester und 280 Teilen Ethylenglykol-monomethyletheracetat hergestellt. Es wird wie in Beispiel 1 verfahren. Die Empfindlichkeit beträgt 70 mJ/$cm^2$.

Beispiel 6

Eine Photoresistlösung gemäß Beispiel 5 hergestellt wird wie in Beispiel 1 jedoch ohne postbake-Schritt (Erhitzen auf 80°C/1 Minute) verarbeitet. Die Empfindlichkeit beträgt 30 mJ/$cm^2$.

## Patentansprüche

**1.** Strahlungsempfindliches Gemisch, im wesentlichen bestenend aus

(a) einem einem in Wasser unlöslichen, in wäßrig-alkalischen Lösungen löslichen Binaemittel oder Bindemittelgemisch,

(b) einer bei Bestrahlung eine starke Säure bildenden Verbindung und

(c) einer oder menreren Löslichkeit von (a) in wäßrig-alkalischen Lösungen inhibierenden organischen Verbindungen,

dadurch gekennzeichnet, daß als organische Verbindung (c) ein β-Ketosäureester der allgemeinen Formel (I)

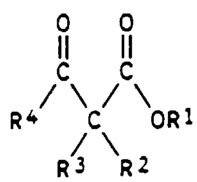

(I)

ist, worin

$R^1$ = Alkyl, Cycloalkyl, Aralkyl oder sauerstoffhaltiger heterocyclischer Rest,

$R^2$ und $R^3$ untereinander gleich oder verschieden sind und für Wasserstoff, Halogen, Alkyl, Cycloalkyl, Aralkyl, Aryl, Alkoxy oder $-CO-OR^1$ stehen, oder $R^1$ mit $R^2$, oder $R^3$ mit $R^4$ über $-(CH_2)_n-$ mit n = 2 bis 5 jeweils einen Ring bilden;

R4 = Alkyl, Cycloalkyl, $-CH_2-CO-OR^1$ oder Aryl,

oder mindestens eine Verbindung aus der Gruppe Acetessigsäure-trimethylsilylester, Propionylmalonsäure-di(trimethylsilyl)ester, Benzoyl-malonsäure-di(trimethylsilyl)ester, Acetylbrommalonsäure-cycloisopropylidenester, Acetylmethylmalonsäure-cycloisopropylidenester, Brom-propionylmalonsäure-cycloisopropylidenester, MethylpropionylmalansäUre-cycloisopropylidenester, Verbindungen der Formel

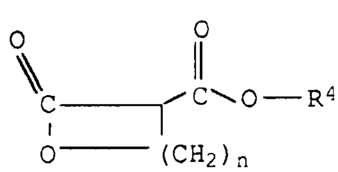

mit n = 2 bis 4 und Verbindungen der allgemeinen Formel (IV)

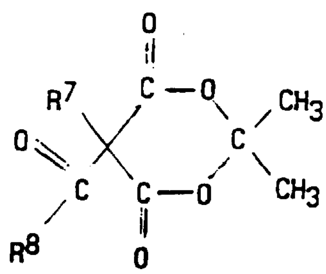

(IV)

worin

$R^7$ = Br oder $CH_3$
$R^8$ = $CH_3$ oder $C_2H_5$,

eingesetzt wird.

2. Strahlungsempfindliches Gemisch nach Anspruch 1, dadurch gekennzeichnet, daß als Bindemittel (a) ein phenolisches Harz eingesetzt wird.

3. Strahlungsempfindliches Gemisch nach Anspruch 2, dadurch gekennzeichnet, daß als phenolisches Harz ein Novolak mit einem mittleren Molekulargewicht $\overline{M}_n$ zwischen 300 und 20.000 eingesetzt wird.

4. Strahlungsempfindliches Gemisch nach Anspruch 1, dadurch gekennzeichnet, daß als Bindemittel (a) Poly(p-hydroxystyrol), Poly(p-hydroxy-α-methylstyrol) oder ein Copolymerisat aus p-Hydroxystyrol und p-tert.-Butoxycarbonyloxistyrol eingesetzt wird.

5. Strahlungsempfindliches Gemisch nach Anspruch 1, dadurch gekennzeichnet, daß als Bindemittel (a) ein Copolymerisat aus p-Hydroxystyrol und Alkoxystyrol eingesetzt wird.

6. Strahlungsempfindliches Gemisch nach Anspruch 1, dadurch gekennzeichnet, daß als Bindemittel (a) ein Copolymerisat aus p-Hydroxystyrol und 2-Tetrahydropyranyloxistyrol eingesetzt wird.

7. Strahlungsempfindliches Gemisch nach einem der vorhergehenden Ansprüche, dadurch gekennzeichnet, daß als bei Bestrahlung eine starke Säure bildende Verbindung (b) ein Sulfoniumsalz der allgemeinen Formel (II)

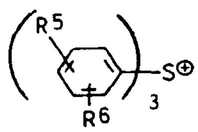

$X^{\ominus}$ (II)

eingesetzt wird, worin $R^5$ und $R^6$ untereinander gleich oder verschieden sind und für H, OH oder einen der Reste

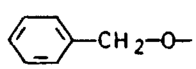 , $(C_1$- bis $C_4$-Alkyl$)_3Si-O-$ , 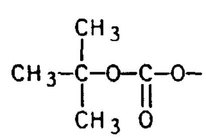 ,

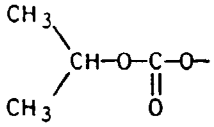 , 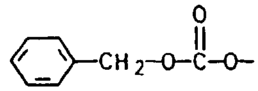

stehen und $X^{\ominus}$ = $Cl^{\ominus}$, $Br^{\ominus}$, $ClO_4^{\ominus}$, Hexafluoroarsenat, Hexafluoroantimonat, Hexafluorophosphat und/oder Tetrafluoroborat ist.

**8.** Strahlungsempfindliches Gemisch nach Anspruch 7, dadurch gekennzeichnet, daß als bei Bestrahlung eine starke Säure bildende Verbindung (b) anstelle des Sulfoniumsalzes der allgemeinen Formel (II) ein Iodoniumsalz der allgemeinen Formel (III)

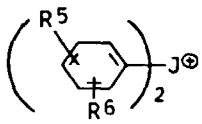 $X^{\ominus}$ (III),

worin $R^5$, $R^6$ und $X^{\ominus}$ die in Anspruch 7 angegebene Bedeutung haben, eingesetzt wird.

**9.** Strahlungsempfindliches Gemisch nach einem der vorhergehenden Ansprüche, dadurch gekennzeichnet, daß als β-Ketosäureester der allgemeinen Formel (I) mindestens ein Acetessigsäureester aus der Gruppe Acetessigsäure-tert.-butylester, Acetessigsäure-isobutylester, Acetessigsäure-2-tetrahydropyranylester, Acetessigsäure-trimethylsilylester und Acetessigsäure-cyclohexylester eingesetzt wird.

**10.** Strahlungsempfindliches Gemisch nach einem der Ansprüche 1 bis 8, dadurch gekennzeichnet, daß als β-Ketosäureester der allgemeinen Formel (I) ein Acetondicarbonsäure-dimethylester, -diethylester oder -di-tert.-butylester eingesetzt wird.

**11.** Strahlungsempfindliches Gemisch nach einem der Ansprüche 1 bis 8, dadurch gekennzeichnet, daß als β-Ketosäureester der allgemeinen Formel (I) mindestens ein Malonsäuredialkylesterderivat aus der Gruppe Acetyl-malonsäuredimethylester, Propionyl-malonsäuredimethylester, Propionyl-malonsäurediethylester, Propionyl-malonsäuredi-tert.-butylester, Acetyl-malonsäuredi-iso-butylester, Propionyl-malonsäuredi(trimethylsilyl)ester und Benzoyl-malonsäure-di(trimethylsilyl)ester eingesetzt wird.

**12.** Verfahren zur Herstellung von Reliefstrukturen oder zur Strukturierung von Wafern durch Auftragen von Photoresistlösungen in einer Schichtdicke von 0,1 bis 5 µm auf ein in üblicher Weise vorbehandeltes Substrat, Trocknen, bildmäßige Belichtung, gegebenenfalls Erhitzen auf Temperaturen von bis zu 150°C, und Entwickeln mit einer wäßrigalkalischen Lösung, wobei Photoresistlösungen eingesetzt werden, die strahlungsempfindliche Gemische nach einem der vorhergehenden Ansprüche enthalten.

## Claims

**1.** A radiation-sensitive mixture essentially consisting of

(a) a water-insoluble binder or binder mixture which is soluble in aqueous alkaline solutions,
(b) a compound which upon irradiation forms a strong acid and
(c) one or more organic compounds which inhibit the solubility of (a) in aqueous alkaline solutions,

wherein the organic compound (c) is a β-ketoacid ester of the general formula (I)

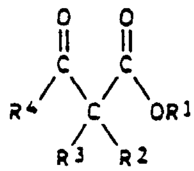

(I)

where

| | |
|---|---|
| $R^1$ is | alkyl, cycloalkyl, aralkyl or an oxygen-containing heterocyclic radical, |
| $R^2$ and $R^3$ are | identical or different and each is hydrogen, halogen, alkyl, cycloalkyl, aralkyl, aryl, alkoxy or $-CO-OR^1$, or $R^1$ together with $R^2$, or $R^3$ together with $R^4$ are linked by $-(CH_2)_n-$, where n is from 2 to 5, to form a ring, and |
| $R^4$ is | alkyl, cycloalkyl, aryl or $-CH_2-CO-OR^1$, |

or at least one compound from the group consisting of trimethylsilyl acetoacetate, di(trimethylsilyl) propionylmalonate, di(trimethylsilyl) benzoylmalonate, cycloisopropylidene acetylbromomalonate, cycloisopropylidene acetylmethylmalonate, cycloisopropylidene bromopropionylmalonate, cycloisopropylidene methylpropionylmalonate, compounds of the formula

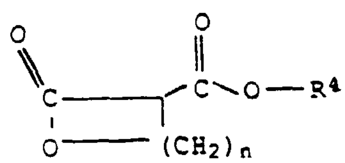

where n is from 2 to 4, and compounds of the general formula (IV)

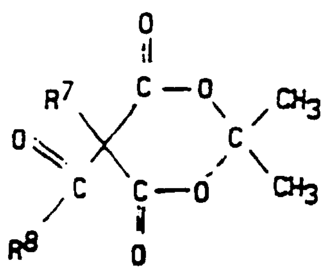

(IV)

where

$R^7$ is Br or $CH_3$ and
$R^8$ is $CH_3$ or $C_2H_5$.

2. A radiation-sensitive mixture as claimed in claim 1, wherein the binder (a) is a phenolic resin.

3. A radiation-sensitive mixture as claimed in claim 2, wherein the phenolic resin is a novolac having a mean molecular weight $\overline{M}_n$ of from 300 to 20,000.

4. A radiation-sensitive mixture as claimed in claim 1, wherein the binder (a) is poly(p-hydroxystyrene), poly(p-hydroxy-a-methylstyrene) or a copolymer of p-hydroxystyrene and p-tert.-butoxycarbonyloxystyrene.

5. A radiation-sensitive mixture as claimed in claim 1, wherein the binder (a) is a copolymer of p-hydroxystyrene and alkoxystyrene.

6. A radiation-sensitive mixture as claimed in claim 1, wherein the binder (a) is a copolymer of p-hydroxystyrene and

2-tetrahydropyranyloxystyrene.

**7.** A radiation-sensitive mixture as claimed in any of the preceding claims, wherein the compound (b), which on irradiation forms a strong acid, is a sulfonium salt of the general formula (II)

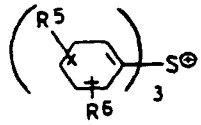 $X^{\ominus}$ (II)

where $R^5$ and $R^6$ are identical or different and each is H, OH or one of the radicals

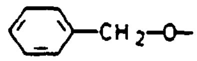 , $(C_1-C_4\text{-alkyl})_3Si-O-$, 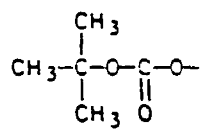 ,

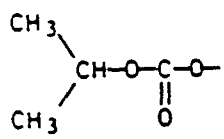 , and 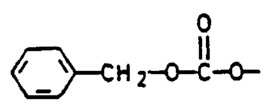

and $X^{\ominus}$ = $Cl^{\ominus}$, $Br^{\ominus}$, $ClO_4^{\ominus}$, hexafluoroarsenate, hexafluoroantimonate, hexafluorophosphate and/or tetrafluoroborate.

**8.** A radiation-sensitive mixture as claimed in claim 7, wherein, in place of the sulfonium salt of the general formula (II), the compound (b), which on irradiation forms a strong acid, is an iodonium salt of the general formula (III)

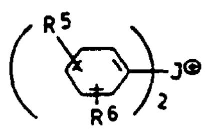 $X^{\ominus}$ (III)

where $R^5$, $R^6$ and $X^{\ominus}$ have the meaning given in claim 7.

**9.** A radiation-sensitive mixture as claimed in any of the preceding claims, wherein the β-ketoacid ester of the general formula (I) consists of one or more acetoacetic acid esters from the group consisting of tert.-butyl acetoacetate, isobutyl acetoacetate, 2-tetrahydropyranyl acetoacetate, trimethylsilyl acetoacetate and cyclohexyl acetoacetate.

**10.** A radiation-sensitive mixture as claimed in any of claims 1 to 8, wherein the β-ketoacid ester of the general formula (I) is dimethyl, diethyl or di-tert.-butyl acetonedicarboxylate.

**11.** A radiation-sensitive mixture as claimed in any of claims 1 to 8, wherein the β-ketoacid ester of the general formula (I) consists of one or more dialkyl malonate derivatives from the group consisting of dimethyl acetylmalonate, dimethyl propionylmalonate, diethyl propionylmalonate, di-tert.-butyl propionylmalonate, di-iso-butyl acetylmalonate, di(trimethylsilyl) propionylmalonate and di(trimethylsilyl) benzoylmalonate.

**12.** A process for the preparation of relief structures or for the structuring of wafers by applying a photoresist solution in a thickness of from 0.1 to 5 µm onto a conventionally pretreated substrate, drying the coating, exposing it imagewise with or without subsequent heating at up to 150°C, and developing with an aqueous alkaline solution, where the photoresist solution employed contains a radiation-sensitive mixture as claimed in any of the preceding claims.

## Revendications

**1.** Mélange sensible aux radiations, composé essentiellement de :

a) un liant ou mélange de liants insoluble dans l'eau, soluble dans des solutions alcalines aqueuses,
b) un composé formant un acide fort par rayonnement, et
c) un ou plusieurs composés organiques inhibant la solubilité de a) dans les solutions alcalines aqueuses,

caractérisé par le fait qu'est incorporé, en tant que composé organique c), un ester β-cétonique de formule générale (I),

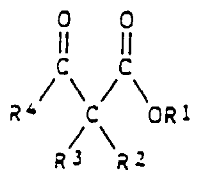

( I )

où

$R^1$ = alkyle, cycloalkyle, aralkyle ou groupe hétérocyclique contenant de l'oxygène

$R^2$ et $R^3$, identiques ou différents, représentant hydrogène, halogène, alkylcycloalkyle, aralkyle, aryle, alkoxy ou -CO-OR$^1$, ou bien $R^1$ avec $R^2$ ou $R^3$ avec $R^4$ forment chaque fois un cycle par l'intermédiaire de $-(CH_2)_n$ avec n = 2 à 5,

$R^4$ = alkyle, cycloalkyle, $-CH_2-CO-OR^1$ ou aryle,

ou au moins un composé choisi dans le groupe constitué par : triméthylsilylester d'acide acétique, di(triméthylsilyl) ester d'acide propionylmalonique, di(triméthylsilyl ester d'acide benzoyle malonique, cycloisopropylidène ester d'acide acétylbromomalonique, cycloisopropylidène ester d'acide acétylméthylmalonique, cycloisopropylidène ester d'acide bromopropionylmalonique, cycloisopropylidène ester d'acide méthylpropionylmalonique, composés de formule

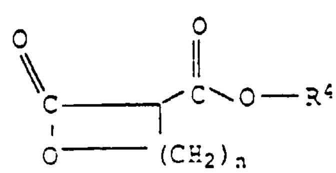

avec n = 2 à 4 et composés de formule générale (IV)

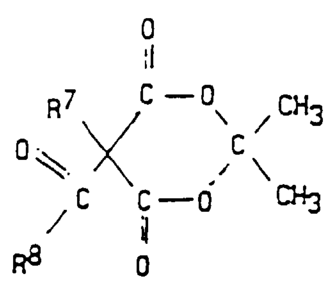

(IV)

où

$R^7$ = Br ou $CH_3$
$R^8$ = $CH_3$ ou $C_2H_5$

**2.** Mélange sensible aux radiations selon la revendication 1, caractérisé par le fait qu'il comporte, comme liant (a), une résine phénolique.

**3.** Mélange sensible aux radiations selon la revendication 2, caractérisé par le fait qu'il comporte, comme résine phénolique, une novolaque à poids moléculaire moyen $\overline{M}_n$ compris entre 300 et 20 000.

**4.** Mélange sensible aux radiations selon la revendication 1, caractérisé par le fait qu'il comporte, comme liant a), du poly (p-hydroxystyrène), poly(p-hydroxyalpha-méthylstyrène) ou un copolymérisat constitué de p-hydroxystyrène et de p-tert-butoxycarbonyloxistyrène.

**5.** Mélange sensible aux radiations selon la revendication 1, caractérisé par le fait qu'y est incorporé, comme liant a), un copolymérisat de p-hydroxystyrène et d'alcoxystyrène.

**6.** Mélange sensible aux radiations selon la revendication 1, caractérisé par le fait qu'y est incorporé, comme liant a), un copolymérisat de p-hydroxystyrène et de 2-tétrahydropyranyl-oxystyrène.

**7.** Mélange sensible aux radiations selon l'une des revendications précédentes, caractérisé par le fait qu'y est incorporé, comme composé b) formant un acide fort par rayonnement, un sel de sulfonium de formule générale (II)

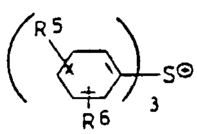 $X^{\ominus}$ (II)

où $R^5$ et $R^6$, identiques ou différents, représentent H, OH ou l'un des restes

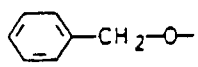 , $(C_1$- à $C_4$-Alkyl$)_3Si-O-$ , 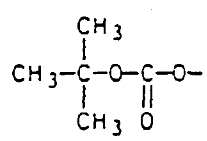 ,

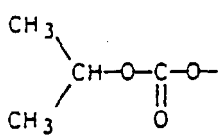 , 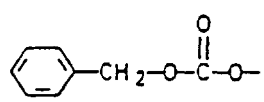

et $X^{\ominus}$ = $Cl^{\ominus}$, $Br^{\ominus}$, $Cl_4^{\ominus}$, hexafluoroarsenate, hexafluoroantimonate, hexafluorophosphate et/ou tétrafluoroborate.

**8.** Mélange sensible aux radiations selon la revendication 7, caractérisé par le fait qu'y est incorporé, comme composé b) formant un acide fort par rayonnement, à la place du sel de sulfonium de formule générale (II), un sel d'iodonium de formule générale (III)

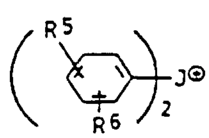 $X^{\ominus}$ (III),

où $R^5$, $R^6$ et $X^-$ ont la signification donnée dans la revendication 7.

9. Mélange sensible aux radiations selon l'une des revendications précédentes, caractérisé par le fait qu'y est incorporé, comme exter β-cétonique de formule générale (I), au moins un ester d'acide acétique choisi dans le groupe formé par : ester tert-butylique d'acide acétique, ester isobutylique d'acide acétique, ester 2-tétrahydropyranylique d'acide acétique, ester triméthylsilylique d'acide acétique et cyclohexyl ester d'acide acétique.

10. Mélange sensible aux radiations selon les revendications 1 à 8, caractérisé par le fait qu'y est incorporé, comme ester β-cétonique de formule générale (I), un ester diméthylique, ester diéthylique ou ester di-tert-butylique d'acide acétonedicarboxylique.

11. Mélange sensible aux radiations selon les revendications 1 à 8, caractérisé par le fait qu'y est incorporé, comme ester β-cétonique de formule générale (I), au moins un dérivé d'ester dialkylique d'acide malonique choisi dans le groupe constitué de : ester diméthylique d'acide acétyl-malonique, ester diméthylique d'acide propionylmalonique, ester diéthylique d'acide propionylmalonique, ester di-tert-butylique d'acide propionylmalonique, ester di-iso-butylique d'acide acétylmalonique, di(triméthylsilyl) ester d'acide propionylmalonique et di(triméthylsilyl) ester d'acide benzoylmalonique.

12. Procédé de préparation de structures en relief ou pour structurisation des tranches de semi-conducteur par application de solutions de photorésists en une épaisseur de couche de 0,1 à 5 microns sur substrat prétraité de façon classique, séchage, exposition à la lumière selon une image, éventuellement chauffage à des températures atteignant 150°C et développement par une solution alcaline aqueuse, des solutions de photo-résists étant incorporées, qui contiennent des mélanges sensibles au rayonnement selon l'une des revendications précédentes.